# EUROPÄISCHE PATENTSCHRIFT

(11) **EP 1 592 097 B1**
(45) Veröffentlichungstag und Bekanntmachung des Hinweises auf die Patenterteilung: **22.08.2012**
(21) Anmeldenummer: 05009057.0
(22) Anmeldetag: 26.04.2005
(51) Int. Cl.: H01R 24/00

(54) **Alien-NEXT-Kompensation an nebeneinander angeordneten Steckverbindern**
Connector with cross-talk compensation
Connecteur avec compensation de diaphonie

(30) Priorität: 26.04.2004 US 831325
(43) Veröffentlichungstag der Anmeldung: 02.11.2005
(73) Patentinhaber: CommScope Solutions Properties, LLC, Sparks, NV 89431 (US)
(72) Erfinder: Hashim, Amid, Plano, TX 75093 (US)
(74) Vertreter: Patentanwälte Bitterich, Dr. Keller, Schwertfeger

(56) Entgegenhaltungen:
- DE-A1- 10 242 143
- US-A1- 2003 109 174
- US-A1- 2003 119 372
- US-B1- 6 305 950

## Beschreibung

Die vorliegende Erfindung betrifft die Fremd-Nahend-Nebensprechkompensation (Alien-NEXT-Kompensation) und insbesondere die Fremd-NEXT-Dämpfung für einzelne, nicht abgeschirmte Twisted-Pair-(UTP-)Steckverbinder, die nebeneinander angeordnet sind.

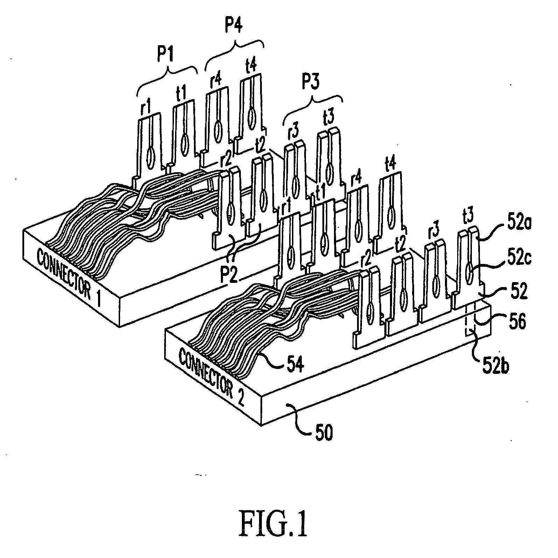

Rauschen oder Signalstörungen zwischen den Leitern von benachbarten Steckverbindern sind als Alien-NEXT bekannt. Fig. 1 zeigt zwei modulare UTP-Steckverbinder 1 und 2, die nebeneinander, z. B. in einem Wandauslass, angeordnet sind. Die Steckverbinder 1 und 2 sind zueinander identisch, die Konfiguration solcher Steckverbinder ist bekannt.

Wie in Fig. 1 dargestellt, weist jeder der Steckverbinder 1 und 2 eine Leiterplatte 50, eine Mehrzahl von Schneidklemmkontakten 52 und eine Mehrzahl von Federdrahtkontakten 54 auf, die oberhalb der Leiterplatte 50 angeordnet und über Leiterbahnen auf der Leiterplatte 50 in geeigneter Weise mit den Schneidklemmkontakten 52 verbunden sind. Die Schneidklemmkontakte 52 an jedem der Steckverbinder 1 und 2 sind zu vier Paaren P1-P4 gruppiert, wobei jedes Paar aus einem mit (r) bezeichneten Minusleiter und einem mit (t) bezeichneten Plusleiter besteht.

Jeder der Schneidklemmkontakte 52 umfasst ein Oberteil 52a mit darin befindlichem Schlitz 52c und ein Unterteil 52b, das in ein entsprechendes plattiertes Durchgangsloch 56 in der Leiterplatte 50 eingesetzt wird. Der Übersichtlichkeit halber ist in Fig. 1 nur ein Loch 56 abgebildet, tatsächlich besitzt die Leiterplatte 50 mehrere plattierte Durchgangslöcher 56 zur Aufnahme der entsprechenden Unterteile 52b der Schneidklemmkontakte 52. Die Federdrahtkontakte 54 passen zu externen Verbindern, und in die Schlitze 52c der Schneidklemmkontakte 52 werden elektrische Drähte in bekannter Weise eingesteckt.

Wenngleich effektiv, unterliegt die Konfiguration der Steckverbinder 1 und 2 insofern einer Einschränkung, als, wenn diese nebeneinander angeordnet werden, kapazitive Kopplung und induktive Kopplung zwischen den Schneidklemmkontakten 52 der beiden Steckverbinder ein Alien-NEXT bewirken. Das Alien-NEXT-Niveau ist zwischen den Paaren der Schneidklemmkontakte 52, die in den beiden Steckverbindern einander gegenüberliegen, am höchsten. Bei diesem Beispiel wird das Alien-NEXT-Niveau zwischen dem zweiten Paar P2 (r2, t2) des Steckverbinders 1 und dem ersten Paar P1 (r1, t1) des Steckverbinders 2 und auch zwischen dem dritten Paar P3 (r3, t3) des Steckverbinders 1 und dem vierten Paar P4 (r4, t4) des Steckverbinders 2 am höchsten sein. Ein solches Alien-NEXT beeinträchtigt die sich über die Steckverbinder ausbreitenden Signale. Dieses Problem ist nicht auf die Steckverbinder 1 und 2 beschränkt, sondern existiert auch bei anderen Steckverbindertypen, wenn diese ohne jede Abschirmvorrichtung nebeneinander angeordnet werden.

Daher besteht die Notwendigkeit, die Alien-NEXT-Niveaus in nebeneinander angeordneten Steckverbindern auf minimale oder akzeptable Werte, z. B. Werte, die 10 Gigabit Ethernet unterstützen würden, zu reduzieren oder zu dämpfen, ohne diese Steckverbinder gegeneinander abschirmen zu müssen.

Aus der US 2003/0119372 A1 sind modulare RJ45-Einsätze bekannt, die mit einer gedruckten Schaltungsplatte verbunden sind, um Hochgeschwindigkeitssignale für Telekommunikationsverbindungen zu übertragen. Die gedruckte Schaltungsplatte ist dafür ausgelegt, das Nahend-Übersprechen (NEXT) zu reduzieren, ohne die Impedanz zu verschlechtern. Das NEXT wird im wesentlichen reduziert durch die Verwendung eines dielektrischen Einsatzes mit niedriger Reaktanz mit einer zweistufigen Kombination von positiver und negativer Kompensationsbeseitigungstechnik. Durch dieses Verfahren soll das Paar-zu-Paar-NEXT wesentlich reduziert und die differenzielle Paarimpedanz kontrolliert werden. Ein Verfahren für die Alien-NEXT-Kompensation ist nicht angegeben.

Aus der US 6 305 950 Bl ist ein modularer Kommunikationsstecker bekannt mit einem Gehäuse, welches eine einen Stecker aufnehmende Öffnung aufweist mit einem leitertragenden Schlitten mit einer gedruckten Schaltungsplatte, die gemäß einem spezifischen Leiterdesign konstruiert ist, und mit zwei Kontaktsätzen, wovon der eine auf der Unterseite und der andere auf der Oberseite der gedruckten Schaltungsplatte angeordnet ist, um die Übersprecheigenschaften zu verbessern. Der Stecker umfasst ferner eine Befestigung für die Drähte. Zur Bestückung werden die Kontakte und die gedruckte Schaltungsplatte mit dem Schlitten verbunden, die Drähte werden in einer Drahtbefestigung positioniert. Schließlich wird die gedruckte Schaltungsplatte aufgeschoben, um die Drähte anzuschließen. Ein Verfahren zum Kompensieren des Alien-NEXT ist nicht angegeben.

Die Erfindung nach Anspruch 1 ermöglicht Steckverbinder mit verbesserter Nebensprechkompensation gegenüber einem benachbarten Steckverbinder. Jeder einzelne Steckverbinder umfasst eine Leiterplatte, eine Mehrzahl von Kontaktpaaren auf der Leiterplatte, eine Mehrzahl von in Randabschnitten der Leiterplatte angeordneten Kompensationsgliedern zur Kompensation des Alien-NEXT und eine Mehrzahl von Verbindungsstücken für die elektrische Verbindung zwischen den Kompensationsgliedern und den Kontaktpaaren. Die Kompensationsglieder der beiden benachbarten Steckverbinder dämpfen die Kapazität/das Nebensprechen, wodurch dann das Alien-NEXT zwischen den Steckverbindern unterdrückt wird. Dank der Erfindung wird die Nebensprechdämpfung entsprechend dem jeweiligen Alien-NEXT-Niveau automatisch angepasst.

Die Aufgabe der Erfindung und ihre Weiterbildungen ergeben sich deutlicher aus der nachfolgenden detaillierten Beschreibung. Es ist jedoch davon auszugehen, dass die detaillierte Beschreibung und die speziellen Beispiele zwar bevorzugte Ausführungsformen der Erfindung darstellen, aber nur veranschaulichenden Charakter haben, da sich verschiedene Änderungen und Modifikationen, die Anwendungsbereich der Erfindung liegen, für den Fachmann aus dieser detaillierten Beschreibung ergeben.

Die Erfindung wird besser verständlich durch die nachfolgende detaillierte Beschreibung und die sie begleitenden Zeichnungen, die lediglich der Veranschaulichung dienen, die Erfindung also in keiner Weise einschränken. Es zeigen
- Fig. 1: ein Beispiel von zwei nebeneinander angeordneten UTP-Steckverbindern nach dem Stand der Technik,
- Fig. 2: ein Beispiel von zwei nebeneinander angeordneten UTP-Steckverbindern gemäß einer Ausführungsform der Erfindung,
- Fig. 3A: eine Innenansicht der in Fig. 2 dargestellten Steckverbinder.
- Fig. 3B: eine Explosionszeichnung von Kompensationsgliedern der in Fig. 3A abgebildeten Steckverbinder,
- Fig. 4: ein Beispiel von Verbindungen zwischen erfindungsgemäßen Kompensationsgliedern und den Schneidklemmkontakten der Steckverbinder nach Fig. 2,
- Fig. 5: ein weiteres Beispiel von Verbindungen zwischen erfindungsgemäßen Kompensationsgliedern und Schneidklemmkontakten zweier benachbarter Steckverbinder und
- Fig. 6: ein drittes Beispiel für die Konfiguration der erfindungsgemäßen Kompensationsglieder.

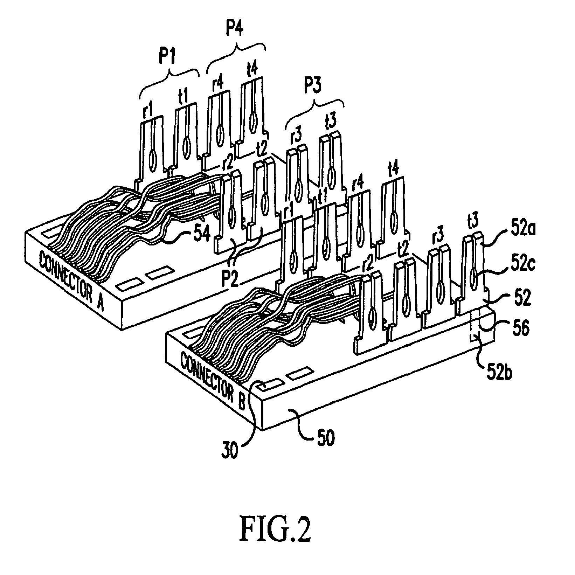

Fig. 2 zeigt ein Beispiel von zwei nebeneinander angeordneten UTP-Steckverbindern A, B gemäß einer Ausführungsform der Erfindung.

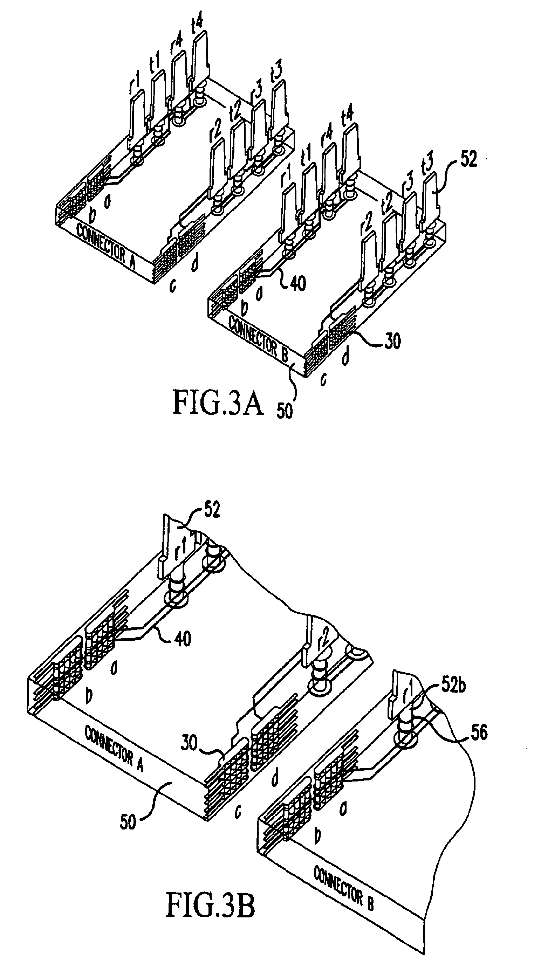

Wie in Fig. 2 dargestellt, weist jeder der Steckverbinder A, B die Merkmale bestehender UTP-Steckverbinder auf, nämlich Schneidklemmkontakte 52 (Paare P1-P4), Leiterplatte 50, plattierte Durchgangslöcher 56 und die Federdrahtkontakte 54, wie in Fig. 1 dargestellt. Jedes der Paare P1-P4 besteht aus einem mit (r) bezeichneten Minuspol und einem mit (t) bezeichneten Pluspol. Jeder der Steckverbinder A, B enthält ferner eine Mehrzahl von Kompensationsgliedern 30 und eine Mehrzahl von Verbindungsstücken 40 (Fig. 3A) für die elektrische Verbindung der erfindungsgemäßen Kompensationsglieder 30 und der Schneidklemmkontakte 52. Die Kompensationsglieder 30 und die Verbindungsstücke 40 bestehen aus leitfähigen Materialien wie Metall.

Fig. 3A zeigt eine Innenansicht der in Fig. 2 dargestellten Steckverbinder, Fig. 3B zeigt eine Explosionsdarstellung der Kompensationsglieder 30 der in Fig. 3A dargestellten Steckverbinder.

Wie in den Fig. 3A und 3B dargestellt, sind die Kompensationsglieder 30a, 30b, 30c, 30d innerhalb der beiden einander gegenüberliegenden Randbereiche jedes Steckverbinders A, B angeordnet. Jedes der Kompensationsglieder 30 kann aus einer einzelnen galvanisierten Schicht oder aus mehreren galvanisierten Schichten bestehen, die übereinander liegen und mittels einer Gruppe plattierter Durchgangslöcher miteinander verbunden sind. Die galvanisierten Schichten der Kompensationsglieder 30 können auf den Oberflächen oder im Innern der Innenschichten der Leiterplatte 50 angeordnet werden. Die oberen und unteren Schichten/Teile der Kompensationsglieder 30 sind an der Ober- und/oder Unterseite der Leiterplatte 50 sichtbar, während sämtliche Innenschichten/Innenteile der Kompensationsglieder 30 im Innern der Leiterplatte 50 angeordnet und von außen nicht zu sehen sind. Diese Konfiguration ist vorzuziehen und bietet Vorteile, da sie ausreichende Kapazitätswerte zulässt und gleichzeitig die Kompensationsglieder 30 von deren oberen und unteren Schichten/Teilen aus zu Testzwecken zugänglich macht. Es ist jedoch auch möglich, die Kompensationsglieder 30 innerhalb der Randabschnitte der Steckverbinder derart einzulassen, dass sie von außen nicht zu sehen sind.

Die Verbindungsstücke 40 können Metallbahnen auf einer oder auf verschiedenen Schichten der Leiterplatte 50 sein, oder es kann sich um auf der Ober- und/oder Unterseite der Leiterplatte 50 angeordnete Metallplatten handeln. Die Verbindungsstücke 40 stehen mit den plattierten Durchgangslöchern 56, die mit den Schneidklemmkontakten 52 verbunden sind, in Kontakt.

Die Steckverbinder A, B sind identisch aufgebaut. So sind zum Beispiel die Lage der Kompensationsglieder 30 und die speziellen, durch die Verbindungsstücke 40 im Steckverbinder A hergestellten Verbindungen identisch mit denjenigen in dem Steckverbinder B, sodass eine Massenfertigung dieser Steckverbinder keine Probleme bereitet.

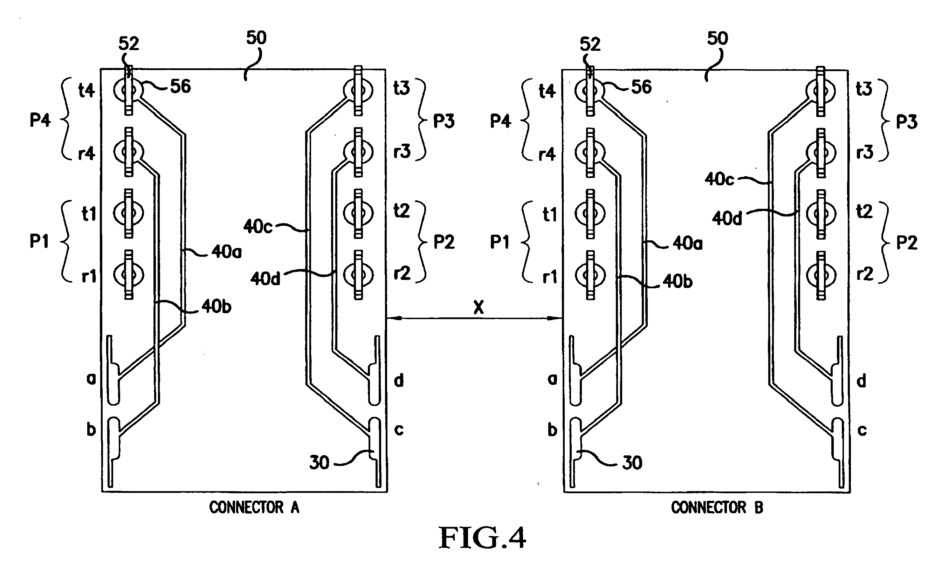

Wie oben erwähnt, wird, da die Steckverbinder A, B nebeneinander liegen, das Alien-NEXT zwischen den Paaren der Schneidklemmkontakte 52 erzeugt und das Alien-NEXT-Niveau ist zwischen zwei einander unmittelbar gegenüberliegenden Paaren der Schneidklemmkontakte 52 am höchsten. Daher werden nachstehend, unter Bezugnahme auf Fig. 4 und lediglich als Beispiel, spezielle Verbindungen besprochen, die zwischen den Kompensationsgliedern 30 und den Schneidklemmkontakten 52 benötigt werden, um das Alien-NEXT zwischen dem dritten Paar P3 des Steckverbinders A und dem vierten Paar P4 des Steckverbinders B, die ungleichnamige Paarnummerierung aufweisen, zu dämpfen. Natürlich beschränkt sich die Erfindung nicht darauf und ist gleichermaßen auf die Dämpfung des Alien-NEXT zwischen anderen Paaren, ebenfalls mit ungleichnamiger Paarnummerierung, der Schneidklemmkontakte benachbarter Steckverbinder anwendbar. Ungleichnamige Paarnummerierung bedeutet verschiedene Paarnummern, z. B. P2 und P4.

Fig. 4 zeigt ein Beispiel von Verbindungen zwischen den Kompensationsgliedern 30 und den Schneidklemmkontakten 52 der erfindungsgemäßen Steckverbinder nach Fig. 2.

Wie in Fig. 4 dargestellt, ist jeder der Steckverbinder A, B mit dem ersten bis vierten Kompensationsglied 30a, 30b, 30c, 30d bestückt, wobei die Kompensationsglieder 30a und 30b innerhalb eines Randabschnitts des Steckverbinders liegen und die Kompensationsglieder 30c und 30d innerhalb eines gegenüberliegenden Randabschnitts des Steckverbinders angeordnet sind. Die Kompensationsglieder 30a und 30b in dem Steckverbinder B liegen den Kompensationsgliedern 30d bzw. 30c in dem Steckverbinder A gegenüber.

In jedem der Steckverbinder A, B umfassen die Verbindungsstücke 40 ein erstes Verbindungsstück 40a, welches das Kompensationsglied 30a elektrisch mit dem Schneidklemmkontakt t4 verbindet, ein zweites Verbindungsstück 40b, welches das Kompensationsglied 30b elektrisch mit dem Schneidklemmkontakt r4 verbindet, ein drittes Verbindungsstück 40c, welches das Kompensationsglied 30c elektrisch mit dem Schneidklemmkontakt t3 verbindet und ein viertes Verbindungsstück 40d, welches das Kompensationsglied 30d elektrisch mit dem Schneidklemmkontakt r3 verbindet. Diese elektrischen Verbindungen kommen zustande, da die Verbindungsstücke 40 mit den entsprechenden Durchgangslöchern 56 in Kontakt sind.

Da die Steckverbinder A, B nebeneinander liegen, wird ein Alien-NEXT bestimmter Polarität durch die Nähe von Leitern gleicher Polung (Pluspol-Pluspol und Minuspol-Minuspol) an den Schneidklemmkontakten 52 erzeugt, und zwar in diesem Beispiel zwischen dem Schneidklemmkontakt t3 des Steckverbinders A und dem Schneidklemmkontakt t4 des Steckverbinders B, beide mit Pluspolung, sowie zwischen dem Schneidklemmkontakt r3 des Steckverbinders A und dem Schneidklemmkontakt r4 des Steckverbinders B, beide mit Minuspolung. Die Erfindung ermöglicht eine Auslöschung dieses Alien-NEXT durch die Nähe von Leitern ungleichnamiger Polung (Minus-Plus und Plus-Minus) an den Kompensationsgliedern 30, und zwar in diesem Beispiel zwischen dem Kompensationsglied 30d des Steckverbinders A, der Minuspolung aufweist, und dem Kompensationsglied 30a des Steckverbinders B, der Pluspolung aufweist, und zwischen dem Kompensationsglied 30c des Steckverbinders A, der Pluspolung aufweist, und dem Kompensationsglied 30b des Steckverbinders B, der Minuspolung aufweist.

Im Einzelnen wird zwischen dem Kompensationsglied 30d des Steckverbinders A und dem Kompensationsglied 30a des Steckverbinders B sowie zwischen dem Kompensationsglied 30c des Steckverbinders A und dem Kompensationsglied 30b des Steckverbinders B Kapazität erzeugt. Da das Kompensationsglied 30d des Steckverbinders A über das vierte Verbindungsstück 40d elektrisch mit dem Schneidklemmkontakt r3 des Steckverbinders A, der Minuspolung aufweist, verbunden ist und das Kompensationsglied 30a des Steckverbinders B über das erste Verbindungsstück 40a elektrisch mit dem Schneidklemmkontakt t4 des Steckverbinders B, der Pluspolung aufweist, verbunden ist, handelt es sich bei der zwischen dem Kompensationsglied 30d des Steckverbinders A und dem Kompensationsglied 30a des Steckverbinders B erzeugten Kapazität tatsächlich um eine Minus-Plus-Kapazität. Ebenso handelt es sich bei der zwischen dem Kompensationsglied 30c des Steckverbinders A und dem Kompensationsglied 30b des Steckverbinders B erzeugten Kapazität tatsächlich um eine Plus-Minus-Kapazität, weil das Kompensationsglied 30c des Steckverbinders A über das dritte Verbindungsstück 40c elektrisch mit dem Schneidklemmkontakt t3 des Steckverbinders A, der Pluspolung aufweist, verbunden ist und weil das Kompensationsglied 30b des Steckverbinders B über das zweite Verbindungsstück 40b elektrisch mit dem Schneidklemmkontakt r4 des Steckverbinders B, der Minuspolung aufweist, verbunden ist. Diese Kopplung zwischen Leitern ungleichnamiger Polung (Minus-Plus und Plus-Minus) an den Kompensationsgliedern 30 bewirkt die Unterdrückung der Kopplung zwischen Leitern gleichnamiger Polung (Plus-Plus und Minus-Minus) an den Schneidklemmkontakten. Dementsprechend stellt die Erfindung eine effektive Möglichkeit zur Unterdrückung des Alien-NEXT von zwei benachbarten Steckverbindern dar.

Während das oben beschriebene Beispiel eine Unterdrückung des Alien-NEXT zwischen dem Paar P3 des Steckverbinders A und dem Paar P4 des Steckverbinders B ermöglicht, beschränkt sich die Erfindung nicht darauf und kann ebenso auf die Unterdrückung des Alien-NEXT zwischen zwei beliebigen anderen Paaren von Schneidklemmkontakten, die einander unmittelbar gegenüberliegen, wie zum Beispiel das Paar P2 des Steckverbinders A und das Paar P1 des Steckverbinders B, Anwendung finden. Dies kann dadurch geschehen, dass im Innern jedes der Steckverbinder A und B Folgendes vorgesehen wird: ein Verbindungsstück für die elektrische Verbindung des Kompensationsglieds 30c mit dem Schneidklemmkontakt t2, ein Verbindungsstück für die elektrische Verbindung des Kompensationsglieds 30d mit dem Schneidklemmkontakt r2, ein Verbindungsstück für die elektrische Verbindung des Kompensationsglieds 30a mit dem Schneidklemmkontakt t1 und ein Verbindungsstück für die elektrische Verbindung des Kompensationsglieds 30b mit dem Schneidklemmkontakt r1.

Des Weiteren ist die Erfindung gleichermaßen anwendbar für die Unterdrückung des Alien-NEXT zwischen einem beliebigen der anderen Paare der benachbarten Steckverbinder, ausgenommen die Paare mit gleicher Nummerierung, wie von dem Paar P3 des Steckverbinders A zum Paar P3 des Steckverbinders B.

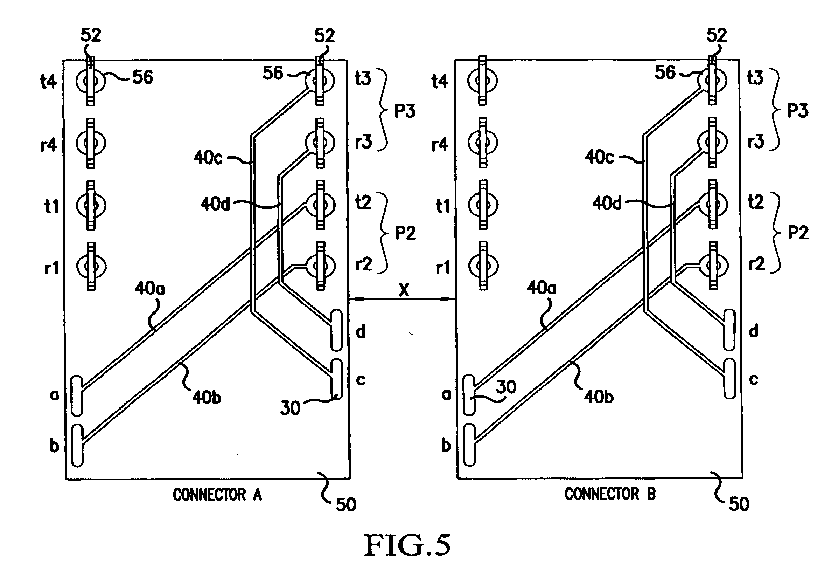

Fig. 5 zeigt ein Beispiel eines Alien-NEXT-Konzepts für die Unterdrückung des Alien-NEXT, welches von Schneidklemmkontakten erzeugt wird, die einander nicht unmittelbar gegenüberliegen, wie das Paar P3 des Steckverbinders A und das Paar P2 des Steckverbinders B. Die Steckverbinder A, B nach Fig. 5 unterscheiden sich von den Steckverbindern A, B der Fig. 2 -4 durch die mittels der Verbindungsstücke 40a-40d hergestellten Verbindungen und die jeweilige Lage der Kompensationsglieder 30.

Wie in Fig. 5 für jeden der Steckverbinder A, B dargestellt, sind die Kompensationsglieder 30 einander diagonal gegenüber an den beiden einander gegenüberliegenden Randabschnitten des Steckverbinders angeordnet. Das erste Verbindungsstück 40a stellt die elektrische Verbindung zwischen dem Kompensationsglied 30a und dem Schneidklemmkontakt t2, das zweite Verbindungsstück 40b stellt die elektrische Verbindung zwischen dem Kompensationsglied 30b und dem Schneidklemmkontakt r2, das dritte Verbindungsstück 40c stellt die elektrische Verbindung zwischen dem Kompensationsglied 30c und dem Schneidklemmkontakt t3 und das vierte Verbindungsstück 40d stellt die elektrische Verbindung zwischen dem Kompensationsglied 30d und dem Schneidklemmkontakt r3 her. Die Kompensationsglieder 30a - 30d befinden sich derart an bestimmten Stellen der Steckverbinder, dass der Versatz zwischen dem Paar P3 des Steckverbinders A gegenüber dem Paar P2 des Steckverbinders B dem Versatz zwischen den Kompensationsgliedern 30d und 30c des Steckverbinders A und den Kompensationsgliedern 30a und 30b des Steckverbinders B entsprechen.

Die Tatsache, dass die Schneidklemmkontakte des Paars P3 des Steckverbinders A den Schneidklemmkontakten des Paars P2 des Steckverbinders B diagonal gegenüberliegen und dass die Polaritäten der einzelnen, diese Paare bildenden Leiter eine ähnliche Reihenfolge aufweisen (bei beiden Steckverbindern Plus zuerst, Minus als zweites), bewirkt das Alien-NEXT einer bestimmten Größenordnung und einer bestimmten Polarität. Während die Kompensationsglieder 30d und 30c des Steckverbinders A den Kompensationsgliedern 30a und 30b in dem Steckverbinder B in ähnlicher Weise diagonal gegenüberliegen, wie die Schneidklemmkontakte P3 des Steckverbinders A den Schneidklemmkontakten P2 des Steckverbinders B diagonal gegenüberliegen, haben die Polaritäten der einzelnen Kompensationsglieder, wie sie durch die Polaritäten der daran über die Verbindungsstücke 40 angeschlossenen Schneidklemmkontakte bestimmt werden, eine entgegengesetzte Reihenfolge (bei Steckverbinder A Minus zuerst, Plus als zweites und bei dem Steckverbinder B Plus zuerst, Minus als zweites). Dies führt zur Erzeugung einer Kompensationskapazität an den Kompensationsgliedern 30, die die gleiche Größenordnung und die entgegengesetze Polarität des an den Schneidklemmkontakten 52 erzeugten Alien-NEXT aufweist.

Während das oben beschriebene Beispiel die Unterdrückung des Alien-NEXT zwischen dem Paar P3 des Steckverbinders A und dem Paar P2 des Steckverbinders B bewirkt, beschränkt sich die Erfindung nicht darauf und ist gleichermaßen auf die Herbeiführung einer Unterdrückung des Alien-NEXT zwischen zwei beliebigen anderen Paaren von Schneidklemmkontakten, die im Verhältnis zueinander diagonal angeordnet sind, wie zum Beispiel das Paar P2 des Steckverbinders A und das Paar P3 des Steckverbinders B, anwendbar. Dies kann durch diagonale Anordnung der Kompensationsglieder 30d und 30c im Verhältnis zu den Kompensationsgliedern 30a und 30b, ähnlich der Art und Weise, in der die Schneidklemmkontakte P2 des Steckverbinders A den Schneidklemmkontakten P3 des Steckverbinders B diagonal gegenüberliegen, und auch dadurch erreicht werden, dass im Innern jedes der Steckverbinder A, B Folgendes vorgesehen wird: ein Verbindungsstück für die elektrische Verbindung des Kompensationsglieds 30c mit dem Schneidklemmkontakt t2, ein Verbindungsstück für die elektrische Verbindung des Kompensationsglieds 30d mit dem Schneidklemmkontakt r2, ein Verbindungsstück für die elektrische Verbindung des Kompensationsglieds 30a mit dem Schneidklemmkontakt t3 und ein Verbindungsstück für die elektrische Verbindung des Kompensationsglieds 30b mit dem Schneidklemmkontakt r3.

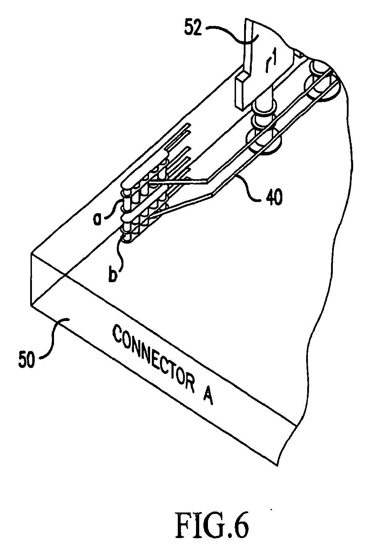

Statt ein Paar Kompensationsglieder vorzusehen, die in einem Steckverbinder nach den Fig. 4 und 5 horizontal nebeneinander angeordnet sind, besteht alternativ die Möglichkeit, für ein Schneidklemmkontaktpaar ein Kompensationsgliederpaar vorzusehen, das vertikal benachbart ist. Dies bedeutet, dass das Kompensationsgliederpaar ohne gegenseitige Berührung übereinander angeordnet wird. Fig. 6 zeigt ein Beispiel einer solchen Konfiguration. Wie in Fig. 6 für jeden der Steckverbinder A, B dargestellt, kann das Kompensationsglied 30a über dem Kompensationsglied 30b angeordnet werden oder umgekehrt.

Die Erfindung bietet ferner den Vorteil, dass der Grad der Nebensprechunterdrückung in Bezug auf Änderungen des die beiden Steckverbinder trennenden Abstandes selbstkorrigierend ist. Gemäß der einmaligen Konfiguration der erfindungsgemäßen Steckverbinder nehmen das störende Nebensprechen (Alien-NEXT) und das unterdrückende Nebensprechen (Kompensationskapazität) in dem Maße zu, wie der Abstand zwischen den Steckverbindern abnimmt, und nehmen in dem Maße ab, wie der Abstand zwischen den Steckverbindern zunimmt. Dementsprechend wird der Umfang der Nebensprechunterdrückung gegenüber dem zwischen den Steckverbindern bestehenden Alien-NEXT proportional und automatisch angepasst.

Wenn im Beispiel nach Fig. 4 der Abstand X zwischen den Steckverbindern A, B abnimmt, nimmt das Alien-NEXT zwischen dem Paar P3 des Steckverbinders A und dem Paar P4 des Steckverbinders B zu. Gleichzeitig nimmt jedoch auch die Nebensprechunterdrückung zu, weil der Abstand zwischen den Kompensationsgliedern 30d und 30c des Steckverbinders A und den Kompensationsgliedern 30a und 30b des Steckverbinders B abnimmt. Daher bewirkt die Erfindung automatisch und in entsprechendem Umfang eine Anpassung der Nebensprechdämpfung, die je nach Umfang des Alien-Nebensprechens zwischen den Steckverbindern A und B zustande kommt.

Dementsprechend können verschiedene Ausführungsformen kombiniert werden, um die gewünschte Konfiguration und Konstruktion bereitzustellen. Ferner kann ein Merkmal einer Ausführungsform/eines Beispiels durch ein Merkmal einer anderen Ausführungsform/eines anderen Beispiels nach Bedarf ersetzt werden.

Nach dieser Beschreibung der Erfindung ist deutlich, dass sie sich in vielerlei Weise variieren lässt. Solche Varianten sind nicht als Abweichung vom Geist und Anwendungsbereich der Erfindung anzusehen und alle derartigen Modifikationen, die dem Fachmann ohne weiteres klar wären, sind als in den nachstehenden Ansprüchen enthalten anzusehen.

## Patentansprüche

1. Steckverbinder (A), umfassend eine gedruckte Leiterplatte (50) und eine Anzahl von Kontaktpaaren (P1, P2, P3, P4) auf der Leiterplatte (50) sowie Kompensationsgliedern (30a -d),
**gekennzeichnet durch**
- eine Anzahl von in einem ersten Randbereich der Leiterplatte (50) angeordneten ersten Kompensationsgliedern (30a, 30b) und von in einem gegenüber liegenden Randbereich der Leiterplatte (50) angeordneten zweiten Kompensationsgliedern (30c, 30d),
- eine Anzahl von Verbindungsstücken (40) für die elektrische Verbindung der Kompensationsglieder (30) mit den Kontaktpaaren (P1 bis P4),
- wobei ein Kontaktpaar (z. B. P3) des Verbinders (A) an ein Kontaktpaar mit ungleichnamiger Paarnummerierung (z. B. P4) eines benachbarten, identischen Verbinders (B) angrenzt und dessen Fremdübersprechen aufnehmen kann
- und wobei das eine Kontaktpaar (z. B. P3) des Verbinders (A) über Verbindungsstücke (40) mit zweiten Kompensationsgliedern (30c, 30d) und das eine Kontaktpaar (z. B. P4) des benachbarten Verbinders (B) über Kreuz mit ersten Kompensationsgliedern (30a, 30b) verbunden ist, wodurch die zweiten Kompensationsglieder (30c, 30d) kompensierendes Übersprechen von ersten Kompensationsgliedern (30a, 30b) des benachbarten Verbinders (B) empfangen, so dass die Stärke der empfangenen Übersprechkompensation an die Stärke des vorhandenen Fremdübersprechens automatisch angepasst ist.

2. Steckverbinder (A), umfassend eine gedruckte Leiterplatte (50) und eine Anzahl von Kontaktpaaren (P1, P2, P3, P4) auf der Leiterplatte (50) sowie Kompensationsgliedern (30a -d),
**gekennzeichnet durch**
- eine Anzahl von in einem ersten Randbereich der Leiterplatte (50) angeordneten ersten Kompensationsgliedern (30a, 30b) und von in einem gegenüber liegenden Randbereich der Leiterplatte (50) diagonal angeordneten zweiten Kompensationsgliedern (30c, 30d),
- eine Anzahl von Verbindungsstücken (40) für die elektrische Verbindung der Kompensationsglieder (30) mit den Kontaktpaaren (P1 - P4),
- wobei ein Kontaktpaar (z. B. P3) des Verbinders (A) diagonal zu einem Kontaktpaar mit ungleichnamiger Paarnummerierung (z. B. P2) eines benachbarten , identischen Verbinders (B) angeordnet ist und so dessen Fremdübersprechen aufnehmen kann
- und wobei das eine Kontaktpaar (z. B. P3) des Verbinders (A) über Verbindungsstücke (40) mit zweiten Kompensationsgliedern (30c, 30d) und das eine Kontaktpaar (z. B. P2) des benachbarten Verbinders (B) mit diagonal angeordneten ersten Kompensationsgliedern (30a, 30b) verbunden ist, wodurch die zweiten Kompensationsglieder (30c, 30d) kompensierendes Übersprechen von den ersten Kompensationsgliedern (30a, 30b) des benachbarten Verbinders (B) empfangen, so dass die Stärke der empfangenen Übersprechkompensation an die Stärke des vorhandenen Fremdübersprechens automatisch angepasst ist.

3. Steckverbinder nach Anspruch 1 oder 2, **dadurch gekennzeichnet, dass** jedes Kompensationsglied (30a, 30b, 30c, 30d) ein Einzelkompensationsglied ist.

4. Steckverbinder nach Anspruch 1 oder 2, **dadurch gekennzeichnet, dass** die Kompensationsglieder (30a, 30b, 30c, 30d) in jedem der Randabschnitte horizontal nebeneinander angeordnet sind.

5. Steckverbinder nach Anspruch 1 oder 2, **dadurch gekennzeichnet, dass** die Kompensationsglieder (30a, 30b, 30c, 30d) in jedem der Randabschnitte vertikal übereinander angeordnet sind.

6. Steckverbinder nach Anspruch 1 oder 2, **dadurch gekennzeichnet, dass** es sich bei den Kontaktpaaren (P1, P2, P3, P4) um Paare von Schneidklemmkontakten (52) handelt, wobei jedes Paar einen ersten, als Pluspol bezeichneten Kontakt (t1, t2, t3, t4) und einen zweiten, als Minuspol bezeichneten Kontakt (r1, r2, r3, r4) aufweist.

7. Steckverbinder nach Anspruch 1 oder 3, **dadurch gekennzeichnet, dass** die Kompensationsglieder erste bis vierte Kompensationsglieder (30a, 30b, 30c, 30d) aufweisen und die Kontaktpaare erste bis vierte Kontaktpaare (P1, P2, P3, P4) aufweisen und dass die Verbindungsstücke (40) aufweisen:
- ein erstes Verbindungsstück (40a) für die elektrische Verbindung des ersten Kompensationsglieds (30a) mit dem Pluspol (t4) des vierten Kontaktpaars (P4) und
- ein zweites Verbindungsstück (40b) für die elektrische Verbindung des zweiten Kompensationsglieds (30b) mit dem Minuspol (r4) des vierten Kontaktpaars (P4).

8. Steckverbinder nach Anspruch 7, **dadurch gekennzeichnet, dass** die Verbindungsstücke ferner aufweisen:
- ein drittes Verbindungsstück (40c) für die elektrische Verbindung des dritten Kompensationsglieds (30c) mit dem Pluspol (t3) des dritten Kontaktpaars (P3) und
- ein viertes Verbindungsstück (40d) für die elektrische Verbindung des vierten Kompensationsglieds (30d) mit dem Minuspol (r3) des dritten Kontaktpaars (P3).

9. Steckverbinder nach Anspruch 2 oder 6, **dadurch gekennzeichnet, dass** die Kompensationsglieder erste bis vierte Kompensationsglieder (30a, 30b, 30c, 30d) und die Kontaktpaare erste bis vierte Kontaktpaare (P1, P2, P3, P4) aufweisen und dass die Verbindungsstücke aufweisen:
- ein drittes Verbindungsstück (40c) für die elektrische Verbindung des ersten Kompensationsglieds (30a) mit dem Pluspol (t1) des ersten Kontaktpaars (P1) und
- ein zweites Verbindungsstück (40b) für die elektrische Verbindung des zweiten Kompensationsglieds (30b) mit dem Minuspol (r1) des ersten Kontaktpaars (P1).

10. Steckverbinder nach Anspruch 9, **dadurch gekennzeichnet, dass** die Verbindungsstücke ferner aufweisen:
- ein drittes Verbindungsstück (40c) für die elektrische Verbindung des dritten Kompensationsglieds (30c) mit dem Pluspol (t2) des zweiten Kontaktpaars (P2) und
- ein viertes Verbindungsstück (40d) für die elektrische Verbindung des vierten Kompensationsglieds (30d) mit dem Minuspol (r2) des zweiten Kontaktpaars (P2).

11. Steckverbinder nach Anspruch 2 oder 6, **dadurch gekennzeichnet, dass** die Kompensationsglieder erste bis vierte Kompensationsglieder (30a, 30b, 30c, 30d) und die Kontaktpaare erste bis vierte Kontaktpaare (P1, P2, P3, P4) aufweisen und dass die Verbindungsstücke aufweisen:
- ein erstes Verbindungsstück (40a) für die elektrische Verbindung des ersten Kompensationsglieds (30a) mit dem Pluspol (t2) des zweiten Kontaktpaars (P2) und
- ein zweites Verbindungsstück (40b) für die elektrische Verbindung des zweiten Kompensationsglieds (30b) mit dem Minuspol (r2) des zweiten Kontaktpaars (P2).

12. Steckverbinder nach Anspruch 11, **dadurch gekennzeichnet, dass** die Verbindungsstücke ferner aufweisen:
- ein drittes Verbindungsstück (40c) für die elektrische Verbindung des dritten Kompensationsglieds (30c) mit dem Pluspol (t3) des dritten Kontaktpaars (P3) und
- ein viertes Verbindungsstück (40d) für die elektrische Verbindung des vierten Kompensationsglieds (30d) mit dem Minuspol (r3) des dritten Kontaktpaars (P3).

13. Steckverbinder nach Anspruch 2 oder 6, **dadurch gekennzeichnet, dass** die Kompensationsglieder erste bis vierte Kompensationsglieder (30a, 30b, 30c, 30d) und die Kontaktpaare erste bis vierte Kontaktpaare (P1, P2, P3, P4) aufweisen und dass die Verbindungsstücke aufweisen:
- ein erstes Verbindungsstück (40a) für die elektrische Verbindung des ersten Kompensationsglieds (30a) mit dem Pluspol (t3) des dritten Kontaktpaars (P3) und
- ein zweites Verbindungsstück (40b) für die elektrische Verbindung des zweiten Kompensationsglieds (30b) mit dem Minuspol (r3) des dritten Kontaktpaars (P3).

14. Steckverbinder nach Anspruch 13, **dadurch gekennzeichnet, dass** die Verbindungsstücke ferner aufweisen:
- ein drittes Verbindungsstück (40c) für die elektrische Verbindung des dritten Kompensationsglieds (30c) mit dem Pluspol (t2) des zweiten Kontaktpaars (P2) und
- ein viertes Verbindungsstück (40d) für die elektrische Verbindung des vierten Kompensationsglieds (30d) mit dem Minuspol (r2) des zweiten Kontaktpaars (P2).

15. Steckverbinder nach Anspruch 1 oder 2, **dadurch gekennzeichnet, dass** die Kompensationsglieder erste und zweite Kompensationsglieder (30a, 30b) in einem ersten Randabschnitt des Steckverbinders (A, B) und dritte und vierte Kompensationsglieder (30c, 30d) in einem zweiten Randabschnitt des Steckverbinders (A, B) aufweisen, wobei das erste und zweite Kompensationsglied (30a, 30b) jeweils dem dritten und vierten Kompensationsglied (30c, 30d) diagonal gegenüberliegt.

16. Steckverbinder (A, B) nach Anspruch 1 oder 2 für die Alien-Nebensprech-Kompensation gegenüber einem benachbarten Steckverbinder (B, A), **dadurch gekennzeichnet, dass** die Mehrzahl von leitfähigen Kompensationsgliedern (30a, 30b, 30c, 30d), die in Randbereichen der Leiterplatte (50) angeordnet sind, gegenüber dem benachbarten Steckverbinder (B, A) Kompensationskapazität entstehen lassen.

## Claims

1. Connector (A), comprising a printed circuit board (50) and a number of contact pairs (P1, P2, P3, P4) on the circuit board (50) as well as compensation elements (30a-d),
**characterised by**
- a number of first compensation elements (30a, 30b) arranged in a first edge region of the circuit board (50) and of second compensation elements (30c, 30d) arranged in an opposite edge region of the circuit board (50),
- a number of connecting pieces (40) for the electrical connection of the compensation elements (30) to the contact pairs (P1 to P4),
- wherein one contact pair (e.g. P3) of the connector (A) adjoins a contact pair with different pair numbering (e.g. P4) of an adjacent, identical connector (B) and can pick up its interfering crosstalk,
- and wherein one contact pair (e.g. P3) of the connector (A) is connected via connecting pieces (40) to second compensation elements (30c, 30d) and one contact pair (e.g. P4) of the adjacent connector (B) is connected via cross to first compensation elements (30a, 30b), as a result of which the second compensation elements (30c, 30d) receive compensating crosstalk from first compensation elements (30a, 30b) of the adjacent connector (B) so that the level of the received crosstalk compensation is adjusted automatically to the level of interfering crosstalk present.

2. Connector (A), comprising a printed circuit board (50) and a number of contact pairs (P1, P2, P3, P4) on the circuit board (50) as well as compensation elements (30a-d),
**characterised by**
- a number of first compensation elements (30a, 30b) arranged in a first edge region of the circuit board (50) and of second compensation elements (30c, 30d) arranged diagonally in an opposite edge region of the circuit board (50),
- a number of connecting pieces (40) for the electrical connection of the compensation elements (30) to the contact pairs (P1 - P4),
- wherein one contact pair (e.g. P3) of the connector (A) is arranged diagonally to a contact pair with different pair numbering (e.g. P2) of an adjacent, identical connector (B) and can thus pick up its interfering crosstalk,
- and wherein one contact pair (e.g. P3) of the connector (A) is connected via connecting pieces (40) to second compensation elements (30c, 30d) and one contact pair (e.g. P2) of the adjacent connector (B) is connected to diagonally arranged first compensation elements (30a, 30b), as a result of which the second compensation elements (30c, 30d) receive compensating crosstalk from the first compensation elements (30a, 30b) of the adjacent connector (B) so that the level of the received crosstalk compensation is adjusted automatically to the level of interfering crosstalk present.

3. Connector according to Claim 1 or 2, **characterised in that** each compensation element (30a, 30b, 30c, 30d) is an individual compensation element.

4. Connector according to Claim 1 or 2, **characterised in that** the compensation elements (30a, 30b, 30c, 30d) are arranged horizontally next to one another in each of the edge portions.

5. Connector according to Claim 1 or 2, **characterised in that** the compensation elements (30a, 30b, 30c, 30d) are arranged vertically on top of one another in each of the edge portions.

6. Connector according to Claim 1 or 2, **characterised in that** the contact pairs (P1, P2, P3, P4) involve pairs of insulation displacement contacts (52), wherein each pair has a first contact (t1, t2, t3, t4) referred to as a positive pole and a second contact (r1, r2, r3, r4) referred to as a negative pole.

7. Connector according to Claim 1 or 3, **characterised in that** the compensation elements have first to fourth compensation elements (30a, 30b, 30c, 30d) and the contact pairs have first to fourth contact pairs (P1, P2, P3, P4) and that the connecting pieces (40) have:
- a first connecting piece (40a) for the electrical connection of the first compensation element (30a) to the positive pole (t4) of the fourth contact pair (P4) and
- a second connecting piece (40b) for the electrical connection of the second compensation element (30b) to the negative pole (r4) of the fourth contact pair (P4).

8. Connector according to Claim 7, **characterised in that** the connecting pieces furthermore have:
- a third connecting piece (40c) for the electrical connection of the third compensation element (30c) to the positive pole (t3) of the third contact pair (P3) and
- a fourth connecting piece (40d) for the electrical connection of the fourth compensation element (30d) to the negative pole (r3) of the third contact pair (P3).

9. Connector according to Claim 2 or 6, **characterised in that** the compensation elements have first to fourth compensation elements (30a, 30b, 30c, 30d) and the contact pairs have first to fourth contact pairs (P1, P2, P3, P4) and that the connecting pieces have:
- a third connecting piece (40c) for the electrical connection of the first compensation element (30a) to the positive pole (t1) of the first contact pair (P1) and
- a second connecting piece (40b) for the electrical connection of the second compensation element (30b) to the negative pole (r1) of the first contact pair (p1).

10. Connector according to Claim 9, **characterised in that** the connecting pieces furthermore have:
- a third connecting piece (40c) for the electrical connection of the third compensation element (30c) to the positive pole (t2) of the second contact pair (P2) and
- a fourth connecting piece (40d) for the electrical connection of the fourth compensation element (30d) to the negative pole (r2) of the second contact pair (P2).

11. Connector according to Claim 2 or 6, **characterised in that** the compensation elements have first to fourth compensation elements (30a, 30b, 30c, 30d) and the contact pairs have first to fourth contact pairs (P1, P2, P3, P4) and that the connecting pieces have:
- a first connecting piece (40a) for the electrical connection of the first compensation element (30a) to the positive pole (t2) of the second contact pair (P2) and
- a second connecting piece (40b) for the electrical connection of the second compensation element (30b) to the negative pole (r2) of the second contact pair (P2).

12. Connector according to Claim 11, **characterised in that** the connecting pieces furthermore have:
- a third connecting piece (40c) for the electrical connection of the third compensation element (30c) to the positive pole (t3) of the third contact pair (P3) and
- a fourth connecting piece (40d) for the electrical connection of the fourth compensation element (30d) to the negative pole (r3) of the third contact pair (P3).

13. Connector according to Claim 2 or 6, **characterised in that** the compensation elements have first to fourth compensation elements (30a, 30b, 30c, 30d) and the contact pairs have first to fourth contact pairs (P1, P2, P3, P4) and that the connecting pieces have:
- a first connecting piece (40a) for the electrical connection of the first compensation element (30a) to the positive pole (t3) of the third contact pair (P3) and
- a second connecting piece (40b) for the electrical connection of the second compensation element (30b) to the negative pole (r3) of the third contact pair (P3).

14. Connector according to Claim 13, **characterised in that** the connecting pieces furthermore have:
- a third connecting piece (40c) for the electrical connection of the third compensation element (30c) to the positive pole (t2) of the second contact pair (P2) and
- a fourth connecting piece (40d) for the electrical connection of the fourth compensation element (30d) to the negative pole (r2) of the second contact pair (P2).

15. Connector according to Claim 1 or 2, **characterised in that** the compensation elements have first and second compensation elements (30a, 30b) in a first edge portion of the connector (A, B) and third and fourth compensation elements (30c, 30d) in a second edge portion of the connector (A, B), wherein the first and second compensation element (30a, 30b) is in each case diagonally opposite the third and fourth compensation element (30c, 30d).

16. Connector (A, B) according to Claim 1 or 2 for alien crosstalk compensation with respect to an adjacent connector (B, A), **characterised in that** the multiplicity of conductive compensation elements (30a, 30b, 30c, 30d), which are arranged in edge regions of the circuit board (50), allow the generation of compensation capacity with respect to the adjacent connector (B, A).

## Revendications

1. Connecteur (A), comprenant une carte de circuit imprimé (50) et une pluralité de paires de contacts (P1, P2, P3, P4) sur la carte de circuit imprimé (50) ainsi que des éléments de compensation (30a - d),
**caractérisé par**
- une pluralité de premiers éléments de compensation (30a, 30b) disposés dans une première zone de bord de la carte de circuit imprimé (50) et de deuxièmes éléments de compensation (30c, 30d) disposés dans une zone de bord opposée de la carte de circuit imprimé (50),
- une pluralité de pièces de liaison (40) pour la liaison électrique des éléments de compensation (30) avec les paires de contacts (P1 à P4),
- ladite une paire de contacts (p. ex. P3) du connecteur (A) étant adjacente à une paire de contacts ayant un numéro de paire différent (p. ex. P4) d'un connecteur (B) voisin identique et pouvant recevoir sa diaphonie exogène
- et ladite une paire de contacts (p. ex. P3) du connecteur (A) étant reliée par des pièces de liaison (40) à des deuxièmes éléments de compensation (30c, 30d) et ladite une paire de contacts (p. ex. P4) du connecteur (B) voisin reliée en croix à des premiers éléments de compensation (30a, 30b), ce qui fait que les deuxièmes éléments de compensation (30c, 30d) reçoivent une diaphonie compensatrice des premiers éléments de compensation (30a, 30b) du connecteur (B) voisin, de sorte que l'intensité de la compensation de diaphonie reçue est adaptée automatiquement à l'intensité de la diaphonie exogène existante.

2. Connecteur (A), comprenant une carte de circuit imprimé (50) et une pluralité de paires de contacts (P1, P2, P3, P4) sur la carte de circuit imprimé (50) ainsi que des éléments de compensation (30a - d),
**caractérisé par**
- une pluralité de premiers éléments de compensation (30a, 30b) disposés dans une première zone de bord de la carte de circuit imprimé (50) et de deuxièmes éléments de compensation (30c, 30d) disposés diagonalement dans une zone de bord opposée de la carte de circuit imprimé (50),
- une pluralité de pièces de liaison (40) pour la liaison électrique des éléments de compensation (30) avec les paires de contacts (P1 à P4),
- ladite une paire de contacts (p. ex. P3) du connecteur (A) étant disposée diagonalement par rapport à une paire de contacts ayant un numéro de paire différent (p. ex. P2) d'un connecteur (B) voisin identique et pouvant ainsi recevoir sa diaphonie exogène
- et ladite une paire de contacts (p. ex. P3) du connecteur (A) étant reliée par des pièces de liaison (40) à des deuxièmes éléments de compensation (30c, 30d) et ladite une paire de contacts (p. ex. P2) du connecteur (B) voisin reliée à des premiers éléments de compensation (30a, 30b) disposés diagonalement, ce qui fait que les deuxièmes éléments de compensation (30c, 30d) reçoivent une diaphonie compensatrice des premiers éléments de compensation (30a, 30b) du connecteur (B) voisin, de sorte que l'intensité de la compensation de diaphonie reçue est adaptée automatiquement à l'intensité de la diaphonie exogène existante.

3. Connecteur selon la revendication 1 ou 2, **caractérisé en ce que** chaque élément de compensation (30a, 30b, 30c, 30d) est un élément de compensation individuel.

4. Connecteur selon la revendication 1 ou 2, **caractérisé en ce que** les éléments de compensation (30a, 30b, 30c, 30d) sont juxtaposés horizontalement dans chacune des sections de bord.

5. Connecteur selon la revendication 1 ou 2, **caractérisé en ce que** les éléments de compensation (30a, 30b, 30c, 30d) sont superposés verticalement dans chacune des sections de bord.

6. Connecteur selon la revendication 1 ou 2, **caractérisé en ce que** les paires de contacts (P1, P2, P3, P4) sont des paires de contacts à déplacement d'isolation (52), chaque paire présentant un premier contact (tl, t2, t3, t4) désigné par pôle positif et un deuxième contact (r1, r2, r3, r4) désigné par pôle négatif.

7. Connecteur selon la revendication 1 ou 3, **caractérisé en ce que** les éléments de compensation présentent des premiers à quatrièmes éléments de compensation (30a, 30b, 30c, 30d) et les paires de contacts des premières à quatrièmes paires de contacts (P1, P2, P3, P4) et que les pièces de liaison (40) présentent :
- une première pièce de liaison (40a) pour la liaison électrique du premier élément de compensation (30a) au pôle positif (t4) de la quatrième paire de contacts (P4) et
- une deuxième pièce de liaison (40b) pour la liaison électrique du deuxième élément de compensation (30b) au pôle négatif (r4) de la quatrième paire de contacts (P4).

8. Connecteur selon la revendication 7, **caractérisé en ce que** les pièces de liaison présentent en outre :
- une troisième pièce de liaison (40c) pour la liaison électrique du troisième élément de compensation (30c) au pôle positif (t3) de la troisième paire de contacts (P3) et
- une quatrième pièce de liaison (40d) pour la liaison électrique du quatrième élément de compensation (30d) au pôle négatif (r3) de la troisième paire de contacts (P3).

9. Connecteur selon la revendication 2 ou 6, **caractérisé en ce que** les éléments de compensation présentent des premiers à quatrièmes éléments de compensation (30a, 30b, 30c, 30d) et les paires de contacts des premières à quatrièmes paires de contacts (P1, P2, P3, P4) et que les pièces de liaison présentent :
- une troisième pièce de liaison (40c) pour la liaison électrique du premier élément de compensation (30a) au pôle positif (t1) de la première paire de contacts (P1) et
- une deuxième pièce de liaison (40b) pour la liaison électrique du deuxième élément de compensation (30b) au pôle négatif (r1) de la première paire de contacts (P1).

10. Connecteur selon la revendication 9, **caractérisé en ce que** les pièces de liaison présentent en outre :
- une troisième pièce de liaison (40c) pour la liaison électrique du troisième élément de compensation (30c) au pôle positif (t2) de la deuxième paire de contacts (P2) et
- une quatrième pièce de liaison (40d) pour la liaison électrique du quatrième élément de compensation (30d) au pôle négatif (r2) de la deuxième paire de contacts (P2).

11. Connecteur selon la revendication 2 ou 6, **caractérisé en ce que** les éléments de compensation présentent des premiers à quatrièmes éléments de compensation (30a, 30b, 30c, 30d) et les paires de contacts des premières à quatrièmes paires de contacts (P1, P2, P3, P4) et que les pièces de liaison présentent :
- une première pièce de liaison (40a) pour la liaison électrique du premier élément de compensation (30a) au pôle positif (t2) de la deuxième paire de contacts (P2) et
- une deuxième pièce de liaison (40b) pour la liaison électrique du deuxième élément de compensation (30b) au pôle négatif (r2) de la deuxième paire de contacts (P2).

12. Connecteur selon la revendication 11, **caractérisé en ce que** les pièces de liaison présentent en outre :
- une troisième pièce de liaison (40c) pour la liaison électrique du troisième élément de compensation (30c) au pôle positif (t3) de la troisième paire de contacts (P3) et
- une quatrième pièce de liaison (40d) pour la liaison électrique du quatrième élément de compensation (30d) au pôle négatif (r3) de la troisième paire de contacts (P3).

13. Connecteur selon la revendication 2 ou 6, **caractérisé en ce que** les éléments de compensation présentent des premiers à quatrièmes éléments de compensation (30a, 30b, 30c, 30d) et les paires de contacts des premières à quatrièmes paires de contacts (P1, P2, P3, P4) et que les pièces de liaison présentent :
- une première pièce de liaison (40a) pour la liaison électrique du premier élément de compensation (30a) au pôle positif (t3) de la troisième paire de contacts (P3) et
- une deuxième pièce de liaison (40b) pour la liaison électrique du deuxième élément de compensation (30b) au pôle négatif (r3) de la troisième paire de contacts (P3).

14. Connecteur selon la revendication 13, **caractérisé en ce que** les pièces de liaison présentent en outre :
- une troisième pièce de liaison (40c) pour la liaison électrique du troisième élément de compensation (30c) au pôle positif (t2) de la deuxième paire de contacts (P2) et
- une quatrième pièce de liaison (40d) pour la liaison électrique du quatrième élément de compensation (30d) au pôle négatif (r2) de la deuxième paire de contacts (P2).

15. Connecteur selon la revendication 1 ou 2, **caractérisé en ce que** les éléments de compensation présentent des premiers et deuxièmes éléments de compensation (30a, 30b) dans une première section de bord du connecteur (A, B) et des troisièmes et quatrièmes éléments de compensation (30c, 30d) dans une deuxième section de bord du connecteur (A, B), les premier et deuxième éléments de compensation (30a, 30b) étant opposés diagonalement aux troisième et quatrième éléments de compensation (30c, 30d), respectivement.

16. Connecteur (A, B) selon la revendication 1 ou 2 pour la compensation de la diaphonie exogène par rapport à un connecteur voisin (B, A), **caractérisé en ce que** la pluralité d'éléments de compensation conducteurs (30a, 30b, 30c, 30d) qui sont disposés dans des zones de bord de la carte de circuit imprimé (50) fait apparaître une capacité de compensation par rapport au connecteur voisin (B, A).
